# EUROPÄISCHE PATENTSCHRIFT

(11) **EP 0 962 511 B1**
(45) Veröffentlichungstag und Bekanntmachung des Hinweises auf die Patenterteilung: **16.11.2005**
(21) Anmeldenummer: 99110077.7
(22) Anmeldetag: 22.05.1999
(51) Int. Cl.: C09K 3/18, C23C 14/12, C03C 17/30, G02B 1/10

(54) **Mittel zur Herstellung von wasserabweisenden Beschichtungen auf optischen Substraten**
Method for providing water repellent coatings on optical substrates
Procédé de préparation d'une couche imperméable sur un substrat optique

(30) Priorität: 05.06.1998 DE 19825100
(43) Veröffentlichungstag der Anmeldung: 08.12.1999
(73) Patentinhaber: Merck Patent GmbH, 64293 Darmstadt (DE)
(72) Erfinder: Anthes, Uwe, 64711 Erbach (DE); Dombrowski, Reiner, 64739 Höchst (DE)

(56) Entgegenhaltungen:
- EP-A- 0 561 016
- EP-A- 0 842 711
- DE-A- 19 539 789
- PATENT ABSTRACTS OF JAPAN vol. 018, no. 415 (C-1233), 4. August 1994 (1994-08-04) & JP 06 122778 A (SHINCRON:KK;OTHERS: 02), 6. Mai 1994 (1994-05-06)
- PATENT ABSTRACTS OF JAPAN vol. 095, no. 003, 28. April 1995 (1995-04-28) & JP 06 340966 A (SEIKO EPSON CORP;OTHERS: 01), 13. Dezember 1994 (1994-12-13)
- PATENT ABSTRACTS OF JAPAN vol. 013, no. 039 (C-563), 27. Januar 1989 (1989-01-27) & JP 63 235466 A (MATSUSHITA ELECTRIC IND CO LTD), 30. September 1988 (1988-09-30)

## Beschreibung

Die Erfindung betrifft ein Mittel zur Herstellung von wasserabweisenden Beschichtungen auf optischen Substraten und die diese Beschichtungen tragenden Substrate.

Es ist verbreiteter Stand der Technik, die Oberfläche von optischen Bauteilen mit dünnen Beschichtungen zu deren Schutz oder zur Erzielung bestimmter Funktionseigenschaften zu versehen. Als derartige optische Bauteile sind im wesentlichen optische Linsen, Brillengläser, Objektive für Kameras, Ferngläser oder für andere optische Geräte, Strahlenteiler, Prismen, Spiegel, Fensterscheiben usw. zu verstehen. Zum einen ist Ziel derartiger Beschichtungen, die Oberfläche von optischen Substraten dahingehend zu vergüten, daß durch Härtung und/oder Erhöhung der chemischen Resistenz Schädigungen durch mechanische, chemische oder Umwelteinflüsse vermieden werden. Dies steht im besonderem Maße bei Substraten aus Kunststoffmaterialien im Vordergrund. Zum anderen werden Oberflächenbeschichtungen zur Verminderung der Reflexion eingesetzt, insbesondere bei Brillengläsern und Objektiven. Hierbei kann bei geeigneter Wahl der Beschichtungsmaterialien, Schichtdicke, ein- oder mehrschichtigem Aufbau aus gegebenenfalls unterschiedlichen Materialien mit differierenden Brechungsindizes eine Reduktion der Reflexion auf unter 1 % über das gesamte sichtbare Strahlungsspektrum erreicht werden.

Zur Erzeugung derartiger Vergütungs- bzw. Antireflexschichten dienen zahlreiche oxidische Materialien, wie etwa SiO₂, TiO₂, ZrO₂, MgO, Al₂O₃, auch Fluoride wie MgF₂ sowie Gemische dieser Stoffe. Die Beschichtung von optischen Substraten erfolgt üblicherweise in der Hochvakuumaufdampftechnik. Hierbei wird das Substrat und eine die Aufdampfsubstanz enthaltende Vorlage in eine entsprechende Hochvakuumaufdampfapparatur plaziert, anschließend wird die Apparatur evakuiert und dann die Substanz durch Erhitzen und/oder Elektronenstrahlverdampfung zur Verdampfung gebracht, wobei sich das Aufdampfmaterial auf der Substratoberfläche als dünne Schicht niederschlägt. Entsprechende Apparaturen und Verfahren sind gängiger Stand der Technik.

Vergütungsschichten dieser Art, insbesondere Antireflexschichten sind jedoch äußerst empfindlich gegenüber Verschmutzungen, beispielsweise durch feuchte bzw. fettige Fingerabdrücke. Durch Verunreinigungen wird die Reflexion stark erhöht; Fingerabdrücke werden deshalb deutlich sichtbar. Eine effektive, den ursprünglichen Reflexionswert wiederherstellende Reinigung gestaltet sich als schwierig. Aus diesem Grund hat es sich durchgesetzt, optische Bauteile zusätzlich mit einer hydrophobisierenden, also wasserabweisenden Beschichtung, zu versehen.

Zur Hydrophobisierung der Oberfläche von optischen Substraten stehen eine Reihe von Stoffen, insbesondere aus der Klasse der Organosiliciumverbindungen zur Verfügung. Es sind dies beispielsweise Silane, Siloxane, Silikone und Silikonöle. Diese Substanzen werden in der Regel im Tauchverfahren oder im Aufschleuderverfahren auf die zu behandelnden Substratoberflächen aufgebracht, wobei diese Substanzen entweder in reiner Form oder als Lösungen eingesetzt werden. Nach Oberflächenbehandlung und gegebenenfalls Abdunsten von Lösungsmittel erfolgt meist eine thermische Nachbehandlung, wodurch die wasserabweisende Beschichtung verfestigt und die Haftung mit dem Substratmaterial bewirkt wird. Man erhält hierdurch in der Regel Beschichtungen mit zufriedenstellenden Eigenschaften bezüglich Hydrophobisierung, Haltbarkeit und Dauerhaftigkeit.

Die durch die Natur der üblichen Hydrophobisierungsmittel bedingte Beschichtungstechnik ist jedoch nachteilig.

So ist es bei der Tauchbeschichtung und der Aufschleudertechnik erforderlich, unter strikten Reinraumbedingungen zu arbeiten um Qualitätsbeeinträchtigungen, etwa durch Staubpartikel, auszuschließen. Weiterhin erfordern diese Techniken zusätzliche Arbeitsgänge mit entsprechenden Apparaturen und Anlagen.

Aus JP 05-215 905 ist ein Verfahren zur Erzeugung von wasserabweisenden Beschichtungen auf optischen Substraten bekannt, bei dem Fluoralkylsilazanverbindungen mittels der Hochvakuumaufdampftechnik auf die Substratoberfläche aufgebracht werden. Dieses Verfahren ist gegenüber den üblichen Tauch- und Aufschleudertechniken dahingehend vorteilhaft, weil es ohne weiteres in bestehenden Hochvakuumaufdampfapparaturen durchgeführt werden kann, etwa gleich im Anschluß an die Bedampfung des Substrates mit Antireflex- oder anderen Vergütungsschichten. Die Perfluoralkylsilazanverbindungen werden bevorzugt in einer Form vorgelegt, bei der ein poröser metallischer Sinterkörper mit der Substanz getränkt ist.

In JP 04-355 404 wird ebenfalls ein metallischer Sinterkörper für die Aufnahme der als Beschichtungsmaterial verwendeten organischen Siliciumverbindungen beschrieben.

JP 08143 332 beschreibt Stahlwolle anstelle von metallischen Sinterkörpern als Trägermaterial für die zu verdampfenden organischen Siliciumverbindungen.

Aus DE 195 39 789 ist ein Sinterkörper aus anorganischen Oxiden für die Aufnahme von Fluoralkylsilanen für die Herstellung wasserabweisender Schichten bekannt.

Die mit dem Beschichtungsmaterial getränkten Sinterkörper werden in eine Hochvakuumaufdampfanlage eingebracht und anschließend in einem widerstandsbeheizten Schiffchen oder mit Hilfe eines Elektronenstrahls das Beschichtungsmaterial verdampft. Wird zum Verdampfen ein Elektronenstrahldampfer verwendet, haben diese Sinterkörper erhebliche Nachteile oder sind sogar unbrauchbar. Ein oxidischer Sinterkörper wirkt als Isolator, lädt sich elektrostatisch auf und erhitzt sich erst bei Erhöhung der Leistung des Elektronenstrahls schlagartig, so daß eine geregelte Verdampfung des Beschichtungsmaterials unmöglich ist. Teilweise verdampft auch das Sintermaterial, so daß die Ausbildung wasserabweisender Schichten verhindert wird. Werden die sehr temperaturstabilen Fluoralkylsilane verwendet, sind metallische Sinterkörper oder Stahlwolle nicht verwendbar. Bei Einsatz von weniger temperaturstabilen Siliciumverbindungen besteht aber auch die Gefahr, daß Teile des Metallkörpers mitverdampfen und die Funktion der wasserabweisenden Schicht negativ beeinflussen.

Aufgabe der Erfindung ist es, ein Mittel zur Herstellung von wasserabweisenden Beschichtungen auf optischen Substraten bereitzustellen, dessen Trägermaterial den elektrischen Strom gut leitet und eine hohe Verdampfungstemperatur besitzt, so daß es für alle in Frage kommenden Beschichtungsmaterialien geeignet ist.

Diese Aufgabe wird gemäß der Erfindung gelöst durch ein Mittel zur Herstellung wasserabweisender Beschichtungen auf optischen Substraten, umfassend einen porösen, elektrisch leitfähigen Formkörper und eine organische Siliciumverbindung, erhältlich durch
a) Mischen eines elektrisch leitenden Trägermaterials aus einem elektrisch leitfähigen Material enthaltend ein leitfähiges Metalloxid, Carbid, Nitrid, Silicid oder Kohlenstoff oder aus einem Gemisch aus einem Metallpulver und einem elektrisch nicht leitfähigen Material mit einem Bindemittel und Verpressen des Gemisches zu einem Presskörper,
b) Sintern des Presskörpers bei 1100 bis 1500°C an Luft zu einemporösen Formkörper,
c) Imprägnieren des Formkörpers mit der organischen Siliciumverbindung und
d) Alterung des imprägnierten Formkörpers durch Lagerung an Luft für mindestens drei Tage.

Es wurde gefunden, daß poröse Formkörper aus einem elektrisch leitenden oder halbleitenden Trägermaterial sehr gut als Träger für organische Siliciumverbindungen geeignet sind und aus ihnen durch Erhitzen mit einem Elektronenstrahl die organischen Siliciumverbindungen mit einer sehr gut kontrollierbaren Geschwindigkeit verdampft werden können. Weiterhin wurde gefunden, daß Formkörper, die nur aus einem Metall bestehen, für sehr temperaturstabile Verbindungen unbrauchbar sind. Unter Formkörper im Sinne der Erfindung werden z. B. Tabletten oder Granulate mit einer Korngröße von 1 bis 4 mm verstanden.

Das elektrisch leitfähige Material gemäß der Erfindung besteht aus einem leitfähigen Metalloxid, aus Carbid, Nitrid oder Silicid, aus Kohlenstoff oder einem Metallpulver. Metallpulver können aber nur im Gemisch mit einem elektrisch nicht leitfähigen Material verwendet werden.

Das leitfähige Metalloxid ist bevorzugt Zinndioxid, das mit Antimon, Fluor, Phosphor, Niob oder Tantal dotiert sein kann. Es sind aber auch Halbleiter, wie beispielsweise Indiumoxid einsetzbar.

Bei Verwendung von Carbiden, beispielsweise Titancarbid, Chromcarbid, Wolframcarbid müssen der organischen Siliciumverbindung geringe Mengen an wäßriger Ammoniaklösung zugesetzt werden.

Geeignete Nitride sind Chromnitrid und Wolframnitrid.

Geeignete Silicide sind Molybdänsilicid, Titansilicid oder Chromsilicid. Als Metallpulver sind Pulver der Metalle Titan, Zirkon, Silicium, Eisen, Chrom oder Nickel geeignet. Die Partikelgröße sollte unter 40 µm liegen. Kohlenstoff ist ebenfalls als leitfähiges Material in Form von Graphitpreßlingen oder Aktivkohlengranulat geeignet.

Als elektrisch nicht leitfähiges Material werden Siliciumdioxid, Aluminiumoxid, Zirkonoxid, Aluminiumsilikat oder Mischungen hiervon verwendet.

Bevorzugt werden Formkörper aus 50 bis 90 Gew.-% eines elektrisch nicht leitfähigen Materials und 10 bis 50 Gew.-% eines Metallpulvers.

Ein besonders bevorzugter Formkörper im Sinne der Erfindung besteht aus 40 bis 50 Gew.-% Aluminiumsilikat und 20 bis 60 Gew.-% Silicium-pulver.

Als organische Siliciumverbindungen werden Verbindungen der allgemeinen Formel I verwendet

CₙF₂ₙ₊₁-(CH₂)ₘ-Si(R¹R²R³) (I)

worin
- R¹: Alkoxy mit 1 bis 3 C-Atomen oder CₙF₂ₙ₊₁-(CH₂)ₘ-Si(R²R³)-O-
- R² , R³: Alkyl oder Alkoxy mit 1 bis 3 C-Atomen
- n: 1 bis 12 und
- m: 1 bis 6
bedeuten.

In den Organosiliciumverbindungen der Formel I ist ein Rest eine Polyfluoralkylgruppe, zusammengesetzt aus einer terminalen Perfluoralkylgruppe mit 1 bis 12 C-Atomen, die über eine Alkylengruppe mit 1 bis 6 C-Atomen mit dem Siliciumatom verbunden ist. Von den weiteren mit dem Siliciumatom verbundenen Resten R¹, R² und R³ ist mindestens ein Rest (R¹) eine Alkoxygruppe mit 1 bis 3 C-Atomen. Die weiteren Reste (R², R³) können Alkyl- oder Alkoxygruppen mit jeweils 1 bis 3 C-Atomen sein. Der Rest R¹ kann auch eine Siloxygruppe sein, in der ein Rest eine vorstehend beschriebene Polyfluoralkylgruppe ist. Die beiden anderen mit dem Siliciumatom verbundenen Reste (R² , R³) können wiederum die bereits definierten Alkyl- oder Alkoxygruppen sein. Typische Verbindungen der Formel I sind beispielsweise
Triethoxy(3,3,4,4,5,5,6,6,7,7,7-undecafluoroheptyl)silan
Triethoxy(3,3,4,4,5,5,6,6,7,7,8,8,8-tridecafluorooctyl)silan
Triethoxy(3,3,4,4,5,5,6,6,7,7,8,8,9,9,10,10,10-heptadecafluoro-decyl)silan
Diethoxymethyl(3,3,4,4,5,5,6,6,7,7,8,8,9,9,10,10,10-heptadecafluorodecyl)silan
Bis[ethoxymethyl(3,3,4,4,5,5,6,6,7,7,8,8,8-tridecafluorooctyl)]silylether

Die Verbindungen der Formel I sind an sich bekannt und überwiegend im Handel erhältlich. Im übrigen sind sie ohne weiteres nach bekannten Herstellverfahren zugänglich.

Die Verbindungen der Formel I sind ausnehmend stabil und insbesondere lagerstabil.

Es hat sich gezeigt, daß sie im Hochvakuum bei Temperaturen zwischen 300 und 500 °C ohne weiteres verdampft werden können, wobei sie sich auf Substratoberflächen unter Bildung dünner Schichten niederschlagen. In diesem Prozeß sind die Verbindungen der Formel I entweder unzersetzlich oder entsprechende Spaltprodukte sind in keinster Weise aggressiv oder korrosiv gegenüber optischen Substraten oder den Bestandteilen von Hochvakuumbedampfungsanlagen, Vakuumpumpen und Pumpenölen.

Geeignete Verbindungen sind außerdem die organischen Siliciumverbindungen, die in der japanischen Patentanmeldung Nr. H06-122 778 beschrieben sind.

Die porösen, elektrisch leitfähigen Formkörper werden hergestellt, indem das Trägermaterial mit einem Bindemittel gemischt und in einer Exzenterpresse zu Tabletten oder Granulat verpreßt wird. Als Bindemittel werden übliche Bindemittel wie Polyvinylalkohol, Glycerin, Methylcellulose, Dextrin, Wachse, einschließlich Polymerwachse verwendet. Die Konzentration des Bindemittels im Preßkörper liegt im Bereich von 1 bis 20 Gew.-%. Die Tabletten haben vorzugsweise einen Durchmesser von 10 bis 15 mm und eine Höhe von 5 bis 10 mm. Das Granulat hat vorzugsweise eine Partikelgröße von 1 bis 4 mm. Die Korngröße des eingesetzten Trägermaterials liegt unter 40 µm, vorzugsweise zwischen 5 und 20 µm.

Anschließend werden die Preßkörper zunächst auf 400 bis 600 °C an Luft erhitzt, um das Bindemittel zu entfernen und dann bei 900 bis 1400 °C über einen Zeitraum von 1 bis 10 Stunden an Luft kalziniert. Die erhaltenen Formkörper sind hart und haltbar und weisen eine Porosität von 40 bis 60 % auf.

In einem nächsten Schritt werden die porösen Formkörper mit den organischen Siliciumverbindungen beladen. Dies geschieht durch Tränken oder Betropfen mit den reinen Verbindungen oder mit Lösungen dieser Verbindungen.

Es ist zweckmäßig, die Formkörper mit vorherbestimmten Mengen an Verbindungen der Formel I zu beladen, da sich durch die quantitative Determinierung des Gehaltes eines jeden solchen beladenen Körpers die Schichtdicke des zu beschichtenden optischen Substrates einfach vorbestimmen läßt.

In einer vierten Herstellungsstufe werden die mit den organischen Siliciumverbindungen beladenen Formkörper an Luft getrocknet und anschließend mindestens 3 Tage, vorzugsweise 7 Tage, an Luft bei Zimmertemperatur gealtert.

Für die Abscheidung wasserabweisender Schichten auf optischen Substraten mit Hilfe des erfindungsgemäßen Mittels können Hochvakuumbedampfungsanlagen, wie sie zur Erzeugung optischer Schichten, wie insbesondere Antireflexschichten oder Vergütungsschichten zur Oberflächenhärtung üblich sind, eingesetzt werden. Hierbei wird der mit der organischen Siliciumverbindung imprägnierte Formkörper anstatt der sonstigen Bedampfungsmaterialien in der Apparatur vorgelegt. Zweckmäßig ist der direkte Anschluß des Bedampfungsschrittes mit Hilfe des erfindungsgemäßen Mittels an vorangehende Bedampfungsschritte, etwa zur Aufbringung von Antireflexschichten, wobei sich das Substrat bereits in der Anlage befindet.

Nachdem der mit der organischen Siliciumverbindung imprägnierte Formkörper in eine konventionelle Hochvakuumbedampfungsanlage eingebracht worden ist, wird nach Erreichen eines stabilen Endvakuums etwa im Bereich zwischen 10⁻³ und 10⁻⁵ mbar die Siliciumverbindung durch Erhitzen auf Temperaturen von 300 bis 500 °C oder mit Hilfe eines Elektronenstrahls verdampft.

Diese schlägt sich im Verlaufe des Prozesses auf der Oberfläche des optischen Substrates unter Bildung einer dünnen Schicht nieder. Zur Verbesserung der Schichthaftung kann es zweckmäßig sein, das Substrat auf eine Temperatur zwischen 50 und 300 °C zu beheizen. Die zu erzielende Schichtdicke ist abhängig von der Prozeßdauer oder bei quantitativer Verdampfung von der Menge an vorgelegter Verbindung. Üblicherweise werden für derartige wasserabweisende Beschichtungen Schichtdicken zwischen 2 und 200 nm eingestellt.

Die mit den genannten Siliciumverbindungen erzeugten wasserabweisenden Beschichtungen zeigen gegenüber den bisher bekannten Beschichtungen einige unvorhersehbare Vorteile. Neben der Tatsache, daß die Beschichtungen ein vorzügliches wasserabweisendes Verhalten zeigen, sind sie gegenüber mechanischen und chemischen Einflüsse erheblich resistenter. Sie sind wesentlich haftfester und haftbarer; ihre Widerstandsfähigkeit gegenüber Wischen und Kratzen sowie ihre Stabilität gegenüber feuchtwarmer Luft, physiologischer Kochsalzlösung, erhöhter Temperatur oder Einwirkung von UV-Strahlung ist wesentlich höher als bei Beschichtungen mit Materialien und Verfahren nach dem Stand der Technik.

Wasserabweisende Schichten mit den genannten Verbindungen können auf allen beliebigen optischen Substraten aufgebracht werden. Ihr Einsatz ist insbesondere vorteilhaft auf optischen Substraten, die vorher mit dünnen Schichten zur Oberflächenvergütung und/oder Reflexionsverminderung versehen worden sind.

Die wasserabweisende Schicht bildet gegenüber Wasser einen Benetzungswinkel von 100 bis 120 °. Wassertropfen perlen von der Schicht ab. Schmutz, wie beispielsweise Fingerabdrücke kann leicht abgewischt werden.

Das erfindungsgemäße Mittel hat den Vorteil, daß es infolge seiner elektrischen Leitfähigkeit problemlos im Elektronenstrahl-Verdampfer eingesetzt werden kann. Es leitet den elektrischen Strom, wodurch es mit einem Elektronenstrahl gleichmäßig aufgeheizt werden kann. Dadurch ist eine sehr genau regelbare Verdampfung der organischen Siliciumverbindungen möglich.

Das erfindungsgemäße Mittel kann ohne Einsatz von zusätzlichen Tiegeln direkt in einen Tiegel des Elektronenstrahl-Verdampfers eingefüllt werden. Durch seine Granulat- oder Tablettenform kann es ohne Schwierigkeiten mit automatischen Nachfüllsystemen eingesetzt werden.

Die folgenden Beispiele sollen die Erfindung erläutern, ohne sie zu begrenzen:

### Beispiel 1

Eine Mischung aus 60 Gew.-% Mullit (Aluminiumsilikat) und 40 Gew.-% Silicium-Pulver wird mit 2 Gew.-% Polyvinylalkohol als Bindemittel versetzt. Aus dem Gemisch werden mit einer Exzenterpresse Tabletten hergestellt mit einem Durchmesser von 13 mm und einer Höhe von 7 mm. Die Tabletten werden zunächst bei etwa 400 bis 600 °C an Luft geglüht, um das Bindemittel zu entfernen. Anschließend werden die Tabletten bei 1100 bis 1150 °C geglüht. Die Tabletten sind dann hart und haltbar.

Anschließend werden die Tabletten mit 0,3 ml einer Mischung aus 1 Vol-Teil Triethoxy(3,3,4,4,5,5,6,6,7,7,7-undecafluoroheptyl)silan und 3 Vol-Teilen 2-Propanol getränkt. Die dotierten Tabletten werden an Luft getrocknet und 7 Tage lang gealtert.

### Beispiel 2

Es wird ein Granulat aus Siliciumcarbid mit einer Teilchengröße von etwa 1-4 mm hergestellt. Dazu wird Siliciumcarbid-Pulver mit einem Bindemittel gemischt und granuliert. Das Granulat wird zunächst bei etwa 400 bis 600 °C an Luft geglüht, um das Bindemittel zu entfernen, und anschließend bei 1400 bis 1500 °C geglüht. Das Granulat ist dann hart und haltbar.

Für die Dotierung wird eine Lösung aus 1 Vol-Teil Triethoxy (3,3,4,4, 5,5,6,6,7,7,7-undecafluoroheptyl)silan und 1 Vol-Teil 2-Propanol mit 15 Vol-% einer 10%igen Ammoniaklösung in Wasser versetzt. Nach einer Reaktionszeit von 15 Minuten wird das Granulat durch Tauchen in die Lösung dotiert. Der Tauchvorgang wird 5 Minuten lang durchgeführt. Anschließend wird das Granulat aus der Lösung genommen. Das Granulat wird an Luft getrocknet und 7 Tage gealtert.

### Beispiel 3

Die Herstellung der wasserabweisenden Schicht wird in einer Aufdampfanlage durchgeführt, wie sie nach dem Stand der Technik für die Beschichtung von Linsen aus Glas oder Kunststoff mit reflexverminderten Schichten eingesetzt werden. Dazu wird eine Tablette in einen Tiegel einer herkömmlichen Elektronenstrahl-Verdampfereinrichtung eingesetzt. Die gereinigten Substrate (mineralisches Glas oder Kunststoff-Glas) werden auf der Substrathaltevorrichtung befestigt. Nach dem Evakuieren der Anlage auf etwa 2*10⁻⁵ mbar wird eine dem Stand der Technik entsprechende Antireflexschicht, zum Beispiel aus 5 Schichten, abwechselnd aus einer hochbrechenden Substanz, z. B. Zirkonoxid und einer niedrigbrechenden Substanz, z. B. Siliciumdioxid, hergestellt. Die letzte Schicht besteht üblicherweise aus Siliciumdioxid.

Auf diese Schicht wird nun die wasserabweisende Schicht aufgebracht, indem man die Tablette nach Beispiel 1 mit dem Elektronenstrahl auf eine Temperatur von etwa 300 bis 400 °C aufgeheizt. Die wasserabweisende Schicht wird bis zu einer Dicke von 5-20 nm aufgedampft.

Die Verdampfung kann auch aus einem handelsüblichen Schiffchen aus Molybdän- oder Tantalblech vorgenommen werden, das direkt durch Stromdurchgang beheizt wird.

## Patentansprüche

1. Mittel zur Herstellung von wasserabweisenden Beschichtungen auf optischen Substraten, umfassend einen porösen, elektrisch leitfähigen Formkörper und eine organische Siliciumverbindung, erhältlich durch
a) Mischen eines elektrisch leitenden Trägermaterials aus einem elektrisch leitfähigen Material enthaltend ein leitfähiges Metalloxid, Carbid, Nitrid, Silicid oder Kohlenstoff oder aus einem Gemisch aus einem Metallpulver und einem elektrisch nicht leitfähigen Material mit einem Bindemittel und Verpressen des Gemisches zu einem Presskörper,
b) Sintern des Presskörpers bei 1100 bis 1500 °C an Luft zu einem porösen Formkörper,
c) Imprägnieren des Formkörpers mit der organischen Siliciumverbindung und
d) Alterung des imprägnierten Formkörpers durch Lagerung an Luft für mindestens drei Tage.

2. Mittel nach Anspruch 1, **dadurch gekennzeichnet, dass** die organische Siliciumverbindung eine Verbindung mit der allgemeinen Formel I ist
CₙF₂ₙ₊₁-(CH₂)ₘ-Si[R¹R²R³) (I)
worin
R¹ Alkoxy mit 1 bis 3 C-Atomen oder CₙF₂ₙ₊₁-(CH₂)ₘ-Si(R²R³)-O-
R², R³ Alkyl oder Alkoxy mit 1 bis 3 C-Atomen
n 1 bis 12 und
m 1 bis 6
bedeuten.

3. Mittel nach Anspruch 1, **dadurch gekennzeichnet, dass** das leitfähige Metalloxid Indiumoxid oder Zinndioxid ist, das mit Antimon, Fluor, Phosphor, Niob oder Tantal dotiert ist.

4. Mittel nach Anspruch 1, **dadurch gekennzeichnet, dass** das Metallpulver aus Titan, Zirkon, Eisen, Chrom, Nickel oder Silicium besteht.

5. Mittel nach Anspruch 1, **dadurch gekennzeichnet, dass** das elektrisch nicht leitfähige Material Siliciumdioxid, Aluminiumoxid, Zirkonoxid, Aluminiumsilikat oder eine Mischung hiervon ist.

## Claims

1. Composition for preparing water-repellent coatings on optical substrates, comprising a porous, electrically conductive moulding and an organosilicon compound and obtainable by
a) mixing an electrically conductive support material made of an electrically conductive material containing a conductive metal oxide, a carbide, nitride, silicide or carbon, or made of a mixture of a metal powder and an electrically non-conductive material, with a binder and subjecting the mixture to compression moulding to form a compression moulding,
b) sintering the compression moulding at from 1100 to 1500°C in air to form a porous moulding,
c) impregnating the moulding with the organosilicon compound, and
d) ageing the impregnated moulding by storage in air for at least 3 days.

2. Composition according to Claim 1, **characterized in that** the organosilicon compound is a compound of the general formula I
CₙF₂ₙ₊₁-(CH₂)ₘ-Si (R¹R²R³) (I)
in which
R¹ is alkoxy of 1 to 3 carbon atoms or CₙF₂ₙ₊₁- (CH₂) ₘ-Si (R²R³) -O-
R², R³ are alkyl or alkoxy of 1 to 3 carbon atoms
n is from 1 to 12 and
m is from 1 to 6.

3. Composition according to Claim 1, **characterized in that** the conductive metal oxide is indium oxide or tin dioxide doped with antimony, fluorine, phosphorus, niobium or tantalum.

4. Composition according to Claim 1, **characterized in that** the metal powder consists of titanium, zirconium, iron, chromium, nickel or silicon.

5. Composition according to Claim 1, **characterized in that** the electrically non-conductive material is silicon dioxide, aluminium oxide, zirconium oxide, aluminium silicate or a mixture thereof.

## Revendications

1. Moyen de préparation de revêtements repoussant l'eau sur des substrats optiques, comprenant un corps formé, poreux, électriquement conducteur et un composé de silicium organique, à obtenir par
a) le mélange d'un matériau porteur électriquement conducteur constitué d'un matériau électriquement conducteur contenant un oxyde métallique conducteur, du carbure, du nitrure, du siliciure ou du carbone ou un mélange d'une poudre métallique et d'un matériau électriquement non conducteur avec un agent liant, et la compression du mélange en un corps comprimé,
b) le frittage du corps comprimé à une température de 1100 à 1500° C à l'air, en un corps formé poreux,
c) l'imprégnation du corps formé avec le composé de silicium organique et
d) le vieillissement du corps formé imprégné par stockage à l'air pendant au moins trois jours.

2. Moyen selon la revendication 1, **caractérisé en ce que** le composé de silicium organique est un composé de formule I générale :
CₙF₂ₙ₊₁- (CH₂)ₘ-Si (R¹R²R³) (I)
dans laquelle
R¹ est un groupe alcoxy présentant de 1 à 3 atomes de carbone ou CₙF₂ₙ₊₁-(CH₂)ₘ-Si(R²R³)-O-
R², R³ sont un groupe alkyle ou alcoxy présentant 1 à 3 atomes de carbone
n vaut 1 à 12 et
m vaut 1 à 6.

3. Moyen selon la revendication 1, **caractérisé en ce que** l'oxyde métallique conducteur est l'oxyde d'indium ou le dioxyde d'étain qui est dopé par l'antimoine, le fluor, le phosphore, le niobium ou le tantale.

4. Moyen selon la revendication 1, **caractérisé en ce que** la poudre métallique est constituée de titane, de zirconium, de fer, de chrome, de nickel ou de silicium.

5. Moyen selon la revendication 1, **caractérisé en ce que** le matériau électriquement non conducteur est le dioxyde de silicium, l'oxyde d'aluminium, l'oxyde de zirconium, le silicate d'aluminium ou leurs mélanges.
